# EUROPEAN PATENT APPLICATION

(11) **EP 4 811 996 A1**
(43) Date of publication of application: **23.09.2026**
(21) Application number: 25165026.3
(22) Date of filing: 20.03.2025
(51) Int. Cl.: H10N 60/01, H10N 60/83, H10N 69/00, H01L 21/768, H01L 23/482

(54) **CO-INTEGRATION OF AIRBRIDGES AND 3D INTEGRATION MODULES**

(71) Applicant: Imec VZW, 3001 Leuven (BE)
(72) Inventor: ANANTHAPADMANABHA RAO, Vadiraj Manjunath, 9051 Gent (BE); DERAKHSHANDEH, Jaber, 3300 Tienen (BE); WAN, Danny, 3000 Leuven (BE)
(74) Representative: Winger

(57) **Abstract**

A method for fabricating one or more airbridge structures and one or more 3D integration modules on a patterned metallization layer of a wafer comprising qubits or superconducting electronics, the method comprising: providing the wafer with the patterned metallization layer; depositing an integrated metallization layer, either before or after providing and patterning a first resist layer; forming one or more airbridge structures which are contacting the patterned metallization layer at openings in the first resist layer, wherein the one or more airbridge structures are made of a superconductive material at operating temperatures; and fabricating 3D integration modules by electroplating predefined regions of the integrated metallization layer.

## Description

### Field of the invention

The invention relates to the field of quantum computing, superconducting electronics and 3D heterogeneous integration. More specifically, it relates to a foundry-compatible method for co-integrating airbridge structures with 3D integration modules, such as bumps, spacers, and through-silicon vias (TSVs)

### Background of the invention

The development of large-scale quantum processors and superconducting digital logic requires heterogeneous 3D integration to enable scalable and efficient qubit architectures and logic. This approach allows for the fabrication of quantum and classical elements on separate chips, which can then be stacked and interconnected to optimize signal routing and minimize footprint. By employing through-silicon vias (TSVs) and bumps, signals can be efficiently distributed across multiple metallization layers, ensuring addressability of quantum and classical elements across the chip.

Among the critical components of quantum and classical processors, airbridges play a key role in mitigating crosstalk between control lines, suppressing parasitic circuit modes that arise from disconnected ground planes, and serving as crossovers to prevent signal collisions in in-plane wiring. These functionalities are essential for preserving signal integrity and ensuring reliable qubit and other classical logic operations.

Traditionally, the fabrication of 3D integration elements for quantum computing has relied on liftoff-based processes, which are not compatible with foundry manufacturing. While liftoff techniques have been sufficient for small-scale quantum circuits, they face challenges in yield, uniformity, and scalability, making them less ideal for the fabrication of large-scale quantum processors with millions of qubits necessary for error correction. The same holds true for superconducting digital logic circuits.

There is therefore a need for alternative methods to fabricate airbridges alongside other 3D integration elements, such as bumps, spacers, and TSVs, to address the limitations of liftoff techniques and provide a pathway towards scalability.

### Summary of the invention

It is an object of embodiments of the present invention to provide a good method for fabricating one or more airbridge structures and 3D integration modules on a patterned metallization layer of a wafer comprising qubits and/or superconducting electronics.

The above objective is accomplished by a method and device according to the present invention.

In a first aspect, embodiments of the present invention relate to a method for fabricating one or more airbridge structures and one or more 3D integration modules on a patterned metallization layer of a wafer comprising qubits and/or superconducting electronics. The method comprises providing the wafer with the patterned metallization layer. An integrated metallization layer is deposited on the wafer, either before or after providing and patterning a first resist layer. One or more airbridge structures are formed on the patterned metallization layer. These one or more airbridge structures are contacting the patterned metallization layer at openings in the first resist layer. The one or more airbridge structures are superconductive at operating temperatures. The one or more airbridge structures are contacting the patterned metallization layer at openings in the first resist layer. At such an opening there is a direct contact between concerned airbridge structure and the integrated metallization layer and a direct contact between the integrated metallization layer and the patterned metallization layer. The integrated metallization layer between the one or more airbridge structures and the patterned metallization layer is superconductive, at operating temperatures, at least due to the proximity effect. Alternatively, the integrated metallization layer provides a galvanic contact between the one or more airbridge structures and the patterned metallization layer with a resistance smaller than a predefined threshold at operating temperatures, for preserving qubit coherence and/or maintaining superconductivity in superconductive electronics. In embodiments of the present invention the qubit coherence is preserved by minimizing resistive losses. In embodiments of the present invention the galvanic contact may have a resistance, at operating temperatures, smaller than 1000 nOhm, or even smaller than 500 nOhm, or even smaller than 100 nOhm, or even smaller than 10 nOhm, or even smaller than 5 nOhm per galvanic contact. The method further comprises fabricating 3D integration modules by electroplating predefined regions of the integrated metallization layer.

It is an advantage of embodiments of the present invention that the method not only provides making airbridges, but also enables making 3D integration modules by performing electroplating. It is an advantage of embodiments of the present invention that the integrated metallization layer enable efficient integration of airbridge structures and subsequent electroplating steps.

In embodiments of the present invention the integrated metallization layer can be used for electroplating the 3D integration modules and as contact between the airbridge structures and the patterned metallization layer.

In embodiments of the present invention the method ensures superconductivity at operating temperatures, preserving qubit coherence by minimizing resistive losses.

Embodiments of the present invention provide a process tailored for large-scale quantum and superconducting digital processors, leveraging a foundry-compatible approach for fabricating airbridge structures and 3D integration modules, such as bumps and spacers. The use of an integrated metallization layer, combining a barrier layer and a seed layer, simplifies the fabrication process and enhances its versatility.

Furthermore, the compatibility with electroplating and the elimination of liftoff techniques improve manufacturing uniformity, yield, and scalability.

In embodiments of the present invention the superconductive material comprises Al, or Ta, or Nb, or TiN.

In embodiments of the present invention the integrated metallization layer comprises a barrier layer and a seed layer.

In embodiments of the present invention the barrier material is superconducting (TiN, TaN, NbTiN, Ta, Nb). It serves as a diffusion barrier for the seed material. In embodiments of the present invention, it also serves as protection layer for the quantum circuit material during 3DI processing.

In embodiments of the present invention the material of the seed layer may for example be Cu or Ru. Ru enables different spacer materials other than Cu.

In embodiments of the present invention the integrated metallization layer may be made of one layer made of a material which is superconductive at the operating temperature and which is also conductive at room temperature for efficient electroplating.

In embodiments of the present invention the method comprises locally etching the seed layer using a same mask as for patterning the first resist layer.

In embodiments of the present invention patterning the first resist layer comprises a reflow step for making tapered sidewalls. This is the case for organic resist. Alternatively, when a hard mask is used tapered sidewalls may be obtained by controlling the etch parameters of the mask.

It is an advantage of embodiments of the present invention that the tapered sidewalls ensure conformal coverage (e.g. after subsequent metal deposition).

In embodiments of the present invention the method comprises depositing the integrated metallization layer before providing and patterning the first resist layer. The one or more airbridge structures are formed by depositing the superconductive material using thin-film deposition. The deposited superconductive material is patterned and etched using a second resist layer to define regions for the one or more airbridge structures, thereby obtaining the one or more airbridge structures. The second resist layer and the first resist layer are then removed. After fabricating the 3D integration modules, the integrated metallization layer is etched to release the one or more airbridge structures and the 3D integration modules.

In embodiments of the present invention the thin-film deposition may be by PVD, CVD, or ALD.

In embodiments of the present invention the method comprises depositing the integrated metallization layer after providing and patterning the first resist layer. The one or more airbridge structures are formed by applying a second resist layer to define regions for the one or more airbridge structures. The superconductive material of the one or more airbridge structures is electroplated in the regions defined by the second resist layer. After fabricating the 3D integration modules, a protection resist is provided to protect the 3D integration modules and the one or more airbridge structures. The integrated metallization layer is then etched, and protection resist material is removed to release the one or more airbridge structures and the 3D integration modules.

It is an advantage of embodiments of the present invention that the method incorporates electroplating to form the superconductive airbridge structures, enabling the deposition of thick, robust materials with well-defined geometries that are essential for shielding, crosstalk mitigation, and mechanical stability. Rhenium (Re), Aluminum (Al), and Ruthenium (Ru) are examples of superconducting materials that can be plated.

In embodiments of the present invention the method comprises depositing the integrated metallization layer after providing and patterning the first resist layer. The one or more airbridge structures are formed by applying a second resist layer to define regions for the one or more airbridge structures. A metal hardmask is electroplated in the regions defined by the second resist layer. After fabricating the 3D integration modules, a protection resist is provided to protect the 3D integration modules while keeping the metal hardmask exposed. The integrated metallization layer is etched except for the regions of the protection resist layer and the regions where the metal hardmask serves as protection. Any remaining metal hardmask is then removed using a resist mask which exposes only the hard mask, followed by the removal of this resist mask to release the one or more airbridge structures.

It is an advantage of embodiments of the present invention that the airbridge structure is fully superconductive based on its material composition, independent of the proximity effect.

In embodiments of the present invention the one or more airbridge structures have a length between contacts on the patterned metallization layer between 20 µm (micrometers) and 100 µm.

In embodiments of the present invention the one or more airbridge structures have a width of more than 10 µm.

It is an advantage of embodiments of the present invention that the airbridge structures can also be used for shielding. They can for example have widths of several hundreds of micrometers.

In embodiments of the present invention the one or more airbridge structures are formed using electroplating and have a width of more than hundred micrometers.

It is an advantage of embodiments of the present invention that the airbridge structures formed using electroplating can achieve widths of more than hundred micrometers, or even up to several hundred micrometers and more, providing enhanced functionality such as electromagnetic shielding and improved mechanical stability. This increased width allows the airbridges to not only serve as signal crossovers but also as effective shields against crosstalk and spurious modes, which are critical for maintaining signal integrity in quantum processors. Furthermore, the use of electroplating ensures the scalability required for fabricating such wide structures, making this method particularly suitable for industrial-scale quantum processor, or superconducting digital logic processors manufacturing where robust and multifunctional components are essential. It is an advantage of embodiments of the present invention that the avoidance of liftoff makes electroplating more compatible with foundry manufacturing.

It is an advantage of embodiments of the present invention that plating allows to create thick mechanically robust structures.

In embodiments of the present invention the electroplating process used for fabricating the 3D integration modules includes forming bumps made of superconducting material to enable superconducting connections between bonded wafers. The bumps may for example be made of Indium or Indium-Tin alloys.

In embodiments of the present invention the electroplating process used for fabricating the 3D integration modules includes forming spacers. Spacer materials can be composed of copper (Cu), ruthenium (Ru), or other suitable metals.

In a second aspect, embodiments of the present invention relate to a method for forming a quantum processor.

The method comprises fabricating airbridge structures and 3D integration modules on a patterned metallization layer of a wafer comprising qubits and/or superconducting electronics, using a method according to the first aspect of the present invention. The method comprises bonding the wafer to an additional wafer, comprising 3D integration modules, using the 3D integration modules of both wafers to establish electrical and mechanical connections.

In embodiments of the present invention at least one of the airbridge structures is configured to mitigate crosstalk and spurious modes in the quantum processor.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 illustrates schematic representations of intermediate stacks obtained during the method steps of an exemplary embodiment of the present invention wherein the integrated metallization layer is deposited before providing and patterning the first resist layer.
FIG. 2 illustrates schematic representations of intermediate stacks obtained during the method steps of an exemplary of the present invention wherein the integrated metallization layer after providing and patterning the first resist layer.
FIG. 3 illustrates schematic representations of intermediate stacks obtained during the method steps of an exemplary embodiment of the present invention wherein a metal hardmask is provided by electroplating.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to "airbridge structures" reference is made to conductive bridges that are elevated above the substrate surface and span over features or gaps of the wafer comprising qubits and/or superconducting electronics. These airbridge structures are made of a material that is superconductive at operating temperatures.

Where in embodiments of the present invention reference is made to "3D integration modules" reference is made to structures formed on a wafer that enable vertical electrical and mechanical connections between stacked wafers or layers in a three-dimensional configuration. These modules are fabricated by performing electroplating on designated regions of the integrated metallization layer. Examples of 3D integration modules include electroplated pillars or bumps made of superconducting material that facilitate inter-wafer connectivity in quantum processors.

Where in embodiments of the present invention reference is made to a "patterned metallization layer" reference is made to a layer of conductive material on a wafer comprising qubits and/or superconducting electronics that has been selectively etched or deposited to define the qubit circuitry and/or superconducting electronics circuitry and associated components. This patterning creates the structures necessary for qubit operation, such as resonators, control lines, and coupling elements. Examples include superconducting layers patterned using photolithography and etching techniques to form superconducting qubits and related circuitry.

Where in embodiments of the present invention reference is made to a "wafer comprising qubits and/or superconducting electronics" reference is made to a semiconductor or insulating substrate on which qubit devices and/or superconducting electronics and associated circuitry are fabricated for use in quantum computing applications. The wafer may serve as the foundational platform for constructing a quantum processor. Examples of wafers include silicon, sapphire, or silicon-on-insulator (SOI) wafers used for implementing superconducting or semiconductor qubits and/or superconducting electronics.

Where in embodiments of the present invention reference is made to an "integrated metallization layer" reference is made to a conductive layer deposited over the wafer comprising qubits and/or superconducting electronics, that serves multiple functions, including acting as a seed layer for electroplating and providing electrical connectivity between various structures. This layer may comprise one or more sub-layers, such as barrier and seed layers, to enhance adhesion and conductivity.

Where in embodiments of the present invention reference is made to a "resist layer" reference is made to a layer of photosensitive or electron-sensitive material applied to the wafer surface that can be patterned using lithographic techniques to define specific areas for processing. The resist layer serves as a mask during etching, deposition, or electroplating processes. Examples include positive or negative photoresists used in ultraviolet lithography to create patterns for subsequent fabrication steps. In embodiments of the present invention a "resist mask" can also be a hard mask that can selectively be removed with respect to other materials on the wafer after its purpose is served.

In embodiments of the present invention the patterned metallization layer of the wafer comprising qubits and/or superconducting electronics, are for a quantum processor. Where in embodiments of the present invention reference is made to a "superconductive material at operating temperatures" reference is made to a material that exhibits superconductivity-zero electrical resistance-at the temperatures at which the quantum processor of qubit devices operate. These operating temperatures are typically cryogenic. Examples of such materials include aluminum, tantalum, niobium, or niobium nitride, which become superconducting below their critical temperatures relevant for quantum computing applications.

Where in embodiments of the present invention reference is made to "operating temperatures" reference is made to the temperatures at which the quantum processor or qubit devices are designed to function effectively, often requiring cryogenic conditions to maintain superconductivity. These operating temperatures may for example be below 4 Kelvin.

Where in embodiments of the present invention reference is made to the "proximity effect" reference is made to the phenomenon where a superconducting property is induced in a non-superconducting material when it is in close contact with a superconducting material due to the penetration of Cooper pairs into the non-superconducting region. This effect allows the integrated metallization layer material between the airbridge structures and the patterned metallization layer to become superconductive.

Where in embodiments of the present invention reference is made to the "reflow step" reference is made to a process wherein the resist layer is heated to a temperature sufficient to cause the resist material to soften and flow, resulting in the smoothening of resist profiles or the formation of tapered sidewalls. This modification aids in subsequent deposition processes by improving material coverage over the resist features. An example is heating a photoresist above its glass transition temperature to achieve tapered sidewalls for better metal step coverage.

Where in embodiments of the present invention reference is made to "electroplating" reference is made to a method of depositing a metal layer onto a conductive surface by passing an electrical current through a solution containing metal ions, causing them to reduce and form a solid metal coating on the cathode surface. This technique is used to fabricate features such as the 3D integration modules and airbridge structures.

Where in embodiments of the present invention reference is made to a "quantum processor" reference is made to a computing device that utilizes the principles of quantum mechanics, such as superposition and entanglement, to perform computations using quantum bits (qubits). The processor comprises qubit devices and associated circuitry fabricated on a wafer comprising qubits and/or superconducting electronics.

Where in embodiments of the present invention reference is made to a "bump" reference is made to a raised metallic feature formed on a wafer surface, typically used to establish electrical and mechanical connections between bonded wafers in flip-chip or wafer-level packaging.

Where in embodiments of the present invention reference is made to a "spacer," reference is made to a raised structure formed on a wafer surface, typically used as a mechanical stop during bonding. The spacer helps to accurately control the gap between bonded chips, ensuring precise alignment and mechanical stability in 3D integration processes. In all embodiments of the present invention the spacer is made of material which can be electroplated. In embodiments of the present invention the spacer is made of metallic material. It is an advantage of embodiments of the present invention that a strong spacer is obtained which resists deformation.

Where in embodiments of the present invention reference is made to a "seed layer" reference is made to a thin conductive film that provides a nucleation site for subsequent metal deposition processes, such as electroplating.

Where in embodiments of the present invention reference is made to a "barrier layer" reference is made to a thin film between the substrate and the seed layer to prevent interdiffusion of materials and enhance adhesion. The barrier layer ensures the integrity of the metallization system during subsequent processing steps. In embodiments of the present invention the barrier layer protects the patterned metallization layer during the full process. In embodiments of the present invention the barrier layer is etched away while preserving the patterned metallization layer.

In a first aspect embodiments of the present invention relate to a method (100) for fabricating one or more airbridge structures (240) and 3D integration modules (251, 252) on a patterned metallization layer (211) of a wafer (210) comprising qubits and/or superconducting electronics. The patterned metallization layer may for example comprise Aluminum (Al), Tantalum (Ta), Niobium (Nb), Titanium Nitride (TiN).

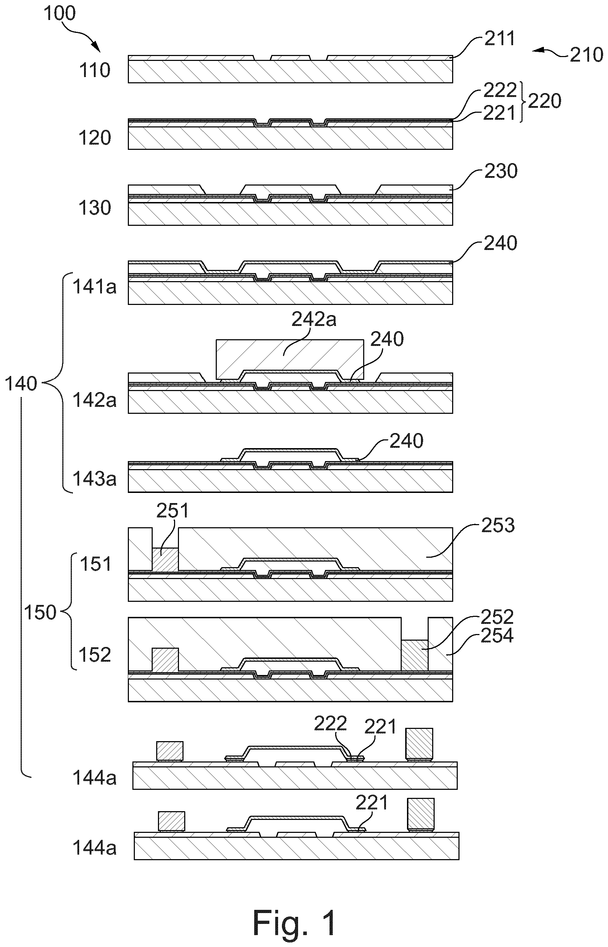

Examples of such methods are illustrated in FIG. 1, FIG. 2 and FIG. 3.

The method (100) comprises providing (110) the wafer (210) with the patterned metallization layer (211). As illustrated in FIG. 1, FIG. 2 and FIG. 3, the wafer (210) comprising qubits and/or superconducting electronics is shown as a rectangular block, representing a substrate, with the patterned metallization layer (211) as a thin layer on top of it.

The method further comprises depositing (120) an integrated metallization layer (220) on the wafer, either before or after providing and patterning (130) a first resist layer (230). One or more airbridge structures (240) are formed (140) on the patterned metallization layer (211). The one or more airbridge structures (240) are contacting the patterned metallization layer (211) at openings in the first resist layer (230). These openings are obtained when patterning the first resist layer (230). The airbridge structures (240) are comprising superconductive material at operating temperatures. The integrated metallization layer (220) between the airbridge structures (240) and the patterned metallization layer (211) is superconductive, at operating temperatures, at least due to the proximity effect, or the integrated metallization layer provides a galvanic contact between the airbridge structures (240) and the patterned metallization layer (211) with a resistance smaller than a predefined threshold, at operating temperatures, for preserving qubit coherence and/or maintaining superconductivity in superconductive electronics by minimizing resistive losses.

The method further comprises fabricating (150) one or more 3D integration modules (251, 252) by electroplating predefined regions of the integrated metallization layer (220). Resist (253, 254) may be provided for defining the regions where the 3D integration modules (251, 252) are electroplated. This resist is removed afterwards.

In embodiments of the present invention the integrated metallization layer (220) comprises a barrier layer (221) and a seed layer (222). This is illustrated in FIGs. 1 to 3. In embodiments of the present invention the barrier material is superconducting, comprising materials such as titanium nitride (TiN), tantalum nitride (TaN), or niobium titanium nitride (NbTiN). It functions as a diffusion barrier to prevent the migration of the seed material (e.g. Cu, Ru). Additionally, it acts as a protective layer for the quantum circuit material during 3D integration processing. In embodiments of the present invention, the barrier layer is used for adhesion purposes for the seed layer.

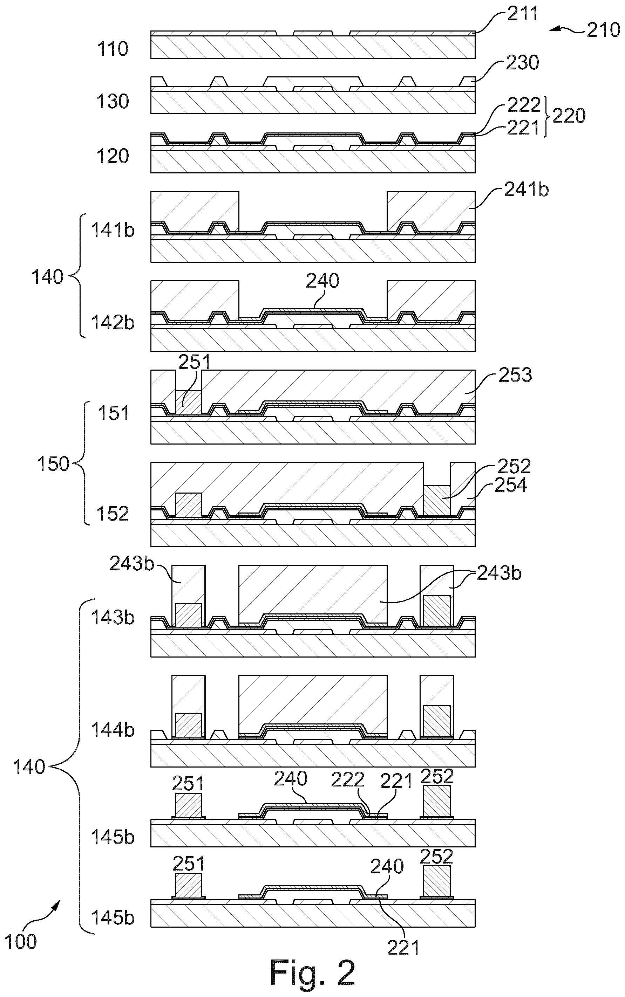

In embodiments of the present invention the method comprising locally etching the seed layer (222) using a same mask as for patterning (130) the first resist layer (230). The result thereof is shown in the bottom stack of FIG. 1 and FIG. 2 which only show the barrier layer (221) between the airbridge structure (240) and the patterned metallization layer (211).

In embodiments of the present invention patterning (130) the first resist layer comprises a reflow step for making tapered sidewalls.

In embodiments of the present invention the integrated metallization layer (220) is deposited before providing and patterning the first resist layer (230). An example of such a method is illustrated in FIG. 1.

In embodiments of the present invention the first resist layer can be composed of an organic resist or a hardmask material.

The one or more airbridge structures (240) are formed (140) by depositing (141a) the superconductive material using thin-film deposition. In embodiments of the present invention conformal coverage is ensured.

The deposited superconductive material is then patterned and etched (142a), using a second resist layer (242a) to define regions for the one or more airbridge structures, thereby obtaining the one or more airbridge structures (240). The etching (142a) of the airbridge metal may be done by wet or dry etching.

The second resist layer (242a) and the first resist layer (230) are subsequently removed (143a) by selective removal with respect to other materials used so far.

The 3D integration modules (251, 252) are fabricated (150).

In embodiments of the present invention a spacer lithography mask (253) is provided and patterned, followed by the electroplating of the spacer material (251). Thus, co-integration of airbridges and spacers is achieved. The spacer material can be copper (Cu) or any other electroplatable superconductor, such as ruthenium (Ru), rhenium (Re), or aluminum (Al). In embodiments of the present invention the selection of the seed layer (222) is influenced by the choice of spacer material.

In embodiments of the present invention a bump lithography mask (254) is patterned, followed by the electroplating of the bump material (252). Thus, co-integration of airbridges and bumps is achieved. The bump material can be indium (In), tin-indium (SnIn) alloy, or any other suitable superconductor. In embodiments of the present invention the selection of the seed layer (222) is influenced by the choice of bump material.

After providing the 3D integration modules (spacer, bump), the lithography mask is removed.

In a following step, the integrated metallization layer (220) is etched (144a) to release the one or more airbridge structures (240) and the 3D integration modules (251, 252). The etching may be wet or dry. In embodiments of the present invention the etching is selective to all the other materials present.

In the exemplary embodiment illustrated in FIG. 2 the method (100) comprises depositing the integrated metallization layer (220) after providing and patterning the first resist layer (230). In embodiments of the present invention the resist layer (230) can be either an organic resist or a hardmask. In embodiments of the present invention the mask undergoes a reflow process to create tapered sidewalls. In embodiments of the present invention the first mask layer is designed so that the open areas on the substrate correspond to the regions where electroplating will be performed.

In embodiments of the present invention the integrated metallization layer consists of a barrier layer and a seed layer. The barrier material is superconducting and can include TiN, TaN, or NbTiN. It functions as a diffusion barrier for the seed material (e.g. Cu or Ru) and also serves as a protective layer for the quantum circuit material during 3D integration processing and also may serve to enhance the adhesion of the seed layer. The seed material can be Cu or Ru, depending on the processing requirements. Alternatively, the integrated metallization layer can be composed of a single superconducting material that fulfills both the barrier and seed layer functions.

The one or more airbridge structures (240) are formed by applying (141b) a second resist layer (241b) to define the regions for the one or more airbridge structures (240). The second resist layer can be an organic resist or a hardmask. In embodiments of the present invention local seed (222) etch may be done using the second resist layer (241b). The resulting stack, without seed layer is illustrated in the bottom drawing of FIG. 2

The superconductive material of the one or more airbridge structures (240) is electroplated (142b) within the regions defined by the second resist layer (241b). In embodiments of the present invention the airbridge metal is a superconductor which can be electroplated such as Ru, Re, Al.

In embodiments of the present invention a spacer lithography mask (253) is provided and patterned, followed by the electroplating of the spacer material (251). Thus, co-integration of airbridges and spacers is achieved. The spacer material can be Cu or any other electroplatable superconductor, such as Ru, Re, or Al. In embodiments of the present invention the selection of the seed layer (222) is influenced by the choice of spacer material.

In embodiments of the present invention a bump lithography mask (254) is patterned, followed by the electroplating of the bump material (252). Thus, co-integration of airbridges and bumps is achieved. The bump material can be In, SnIn alloy, or any other suitable superconductor. In embodiments of the present invention the selection of the seed layer (222) is influenced by the choice of bump material.

A local seed etch can be performed using the bump lithography mask prior to plating the bumps.

After fabricating (150) the 3D integration modules (251, 252), a protection resist (243b) is applied (143b) to protect the 3D integration modules (251, 252) and the one or more airbridge structures (240). These critical structures are protected during the subsequent etching of the integrated metallization layer, ensuring process uniformity.

The integrated metallization layer (220) is then etched (144b), and the resist material is removed (145b) to release the one or more airbridge structures (240) and the 3D integration modules (251, 252). The etching may be wet or dry etching. In embodiments of the present invention the etching is selective to all the other materials present.

Next the protection resist (243b) is removed. Depending on the whether or not a seed etch is performed, a stack with seed layer (222) underneath the airbridge (140) is obtained (second-to-last stack), or a stack without seed layer underneath the airbridge (140) is obtained (bottom stack).

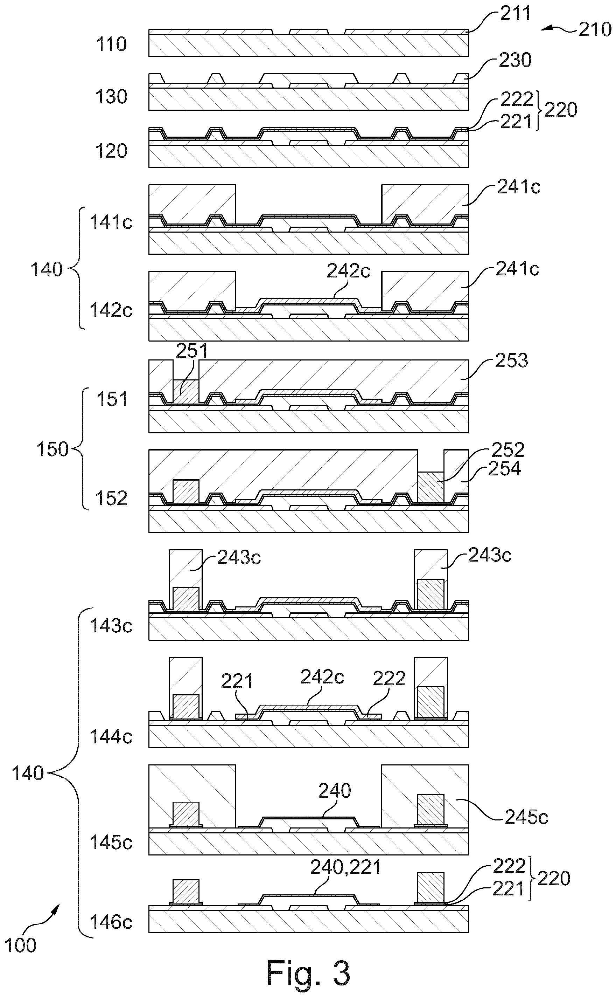

In the exemplary embodiment illustrated in FIG. 3 the method (100) comprises depositing the integrated metallization layer (220) after providing and patterning the first resist layer (230). In embodiments of the present invention the resist layer (230) can be either an organic resist or a hardmask. In embodiments of the present invention the mask undergoes a reflow process to create tapered sidewalls. In embodiments of the present invention the first mask layer is designed so that the open areas on the substrate correspond to the regions where electroplating will be performed.

In embodiments of the present invention the integrated metallization layer consists of a barrier layer and a seed layer. The barrier material is superconducting and can include TiN, TaN, or NbTiN. It functions as a diffusion barrier for the seed material (e.g. Cu) and also serves as a protective layer for the quantum circuit material during 3D integration processing. In embodiments of the present invention the seed material is Cu, and also may serve to enhance the adhesion of the seed layer. Alternatively, the integrated metallization layer can be composed of a single superconducting material that fulfills both the barrier and seed layer functions.

The one or more airbridge structures (240) are formed by applying (141c) a second resist layer (241c) to define regions for the one or more airbridge structures. The second resist layer can be an organic resist or a hardmask.

A metal hardmask (242c) is electroplated (142c) in the regions defined by the second resist layer (241c). In embodiments of the present invention the metal hardmask is made of Cu. The Cu airbridge serves as a hardmask for the subsequent formation of the actual airbridge, which will be superconducting in operating conditions.

In embodiments of the present invention a spacer lithography mask (253) is provided and patterned, followed by the electroplating of the spacer material (251). Thus, co-integration of airbridges and spacers is achieved. The spacer material can be Cu or any other electroplatable superconductor, such as Ru, Re, or Al. In embodiments of the present invention the selection of the seed layer (222) is influenced by the choice of spacer material.

In embodiments of the present invention a bump lithography mask (254) is patterned, followed by the electroplating of the bump material (252). Thus, co-integration of airbridges and bumps is achieved. The bump material can be In, SnIn alloy, or any other suitable superconductor. In embodiments of the present invention the selection of the seed layer (222) is influenced by the choice of bump material.

A local seed etch can be performed using the bump lithography mask prior to plating the bumps.

After fabricating (150) the 3D integration modules (251, 252), a protection resist (243c) is applied (143c) to protect the 3D integration modules (251, 252) while keeping the metal hardmask exposed.

The integrated metallization layer (220) is then etched (144c) except in the regions where the metal hardmask (242c) serves as a protective layer, and in the regions where the protection resist (243c) serves as a protective layer. The etching may be wet or dry etching and is selective to all the other materials present. The etching will also remove part of the hardmask (242c) above the airbridge (240). Since the hardmask (242c) is thicker than the seed layer (222) it will survive the etch step.

In the next step a resist (245c) is applied leaving the remaining metal hardmask (242c) exposed. Any remaining metal hardmask (242c) and seed layer (222) is subsequently removed (145c) and the etching is done selective to the barrier material (221), ensuring that the remaining superconducting barrier material is preserved.

In a next step the resist (245c) is removed (146c) to release the one or more airbridge structures (240) and superconducting bridges are obtained.

In embodiments of the present invention the airbridge structures have a length between contacts on the patterned metallization layer (211) between 20 µm and 100 µm. The length is measured as the shorted distance between the contacts.

In embodiments of the present invention the airbridge structures (240) have a width of more than 10 µm.

The width of the airbridge structure is measured orthogonal to the length (between contacts on the patterned metallization layer) and parallel with the surface of the patterned metallization layer.

In embodiments of the present invention the airbridge structures (240) are formed (130) using electroplating and exhibit a width of more than hundred micrometers.

In embodiments of the present invention the electroplating process used for fabricating (140) the 3D integration modules (251, 252) includes forming bumps made of superconducting material to enable superconducting connections between bonded wafers.

In a second aspect, embodiments of the present invention relate to a method for forming a quantum processor. The method comprises fabricating airbridge structures (240) and 3D integration modules (251, 252) on a patterned metallization layer (211) of a wafer comprising qubits and/or superconducting electronics using the fabrication method (100) described in the first aspect of the invention. The wafer is then bonded to an additional wafer that also comprises 3D integration modules, with the 3D integration modules of both wafers establishing electrical and mechanical connections. This enables the creation of multi-layer quantum processors with enhanced interconnectivity and optimized signal routing. In embodiments of the present invention, at least one of the airbridge structures is configured to mitigate crosstalk and suppress spurious modes in the quantum processor, further improving the overall performance and scalability of the quantum computing system.

It is an advantage of embodiments of the present invention that an integration technique is provided that ensures scalability while preserving quantum coherence.

It is an advantage of embodiments of the present invention that it enables full 3D heterogeneous integration which is necessary for large-scale quantum computing by incorporating bumps, spacers, and through-silicon-via (TSV) modules, which facilitate signal routing and improve qubit addressability in the third dimension.

Airbridges play a critical role in mitigating spurious circuit modes and crosstalk in qubit control and readout lines while also enabling signal crossovers for in-plane wiring.

It is an advantage of embodiments of the present invention that a qubit-compatible process flow is provided that co-integrates airbridges with 3D integration modules, ensuring the advantages of both.

In embodiments of the present invention the method enables the co-integration of airbridges and 3D integration modules within a 300mm foundry-compatible process. The airbridge fabrication process is designed to be compatible with electroplating steps used for 3D integration, ensuring seamless integration with bumps, spacers, and through-silicon vias. Unlike traditional methods that rely on lift-off techniques, which lack scalability and result in high process variability, the proposed approach provides a robust and manufacturable solution suitable for large-scale quantum processor fabrication.

## Claims

1. A method (100) for fabricating one or more airbridge structures (240) and one or more 3D integration modules (251, 252) on a patterned metallization layer (211) of a wafer (210) comprising qubits and/or superconducting electronics, the method comprising:
- providing (110) the wafer (210) with the patterned metallization layer (211);
- depositing (120) an integrated metallization layer (220) on the wafer (210), either before or after providing and patterning (130) a first resist layer (230);
- forming (140) one or more airbridge structures (240) which are contacting the patterned metallization layer (211) at openings in the first resist layer (230),
wherein the one or more airbridge structures (240) are superconductive at operating temperatures, and
wherein the integrated metallization layer (220) between the one or more airbridge structures (240) and the patterned metallization layer (211) is superconductive at operating temperatures, at least due to the proximity effect, or provides a galvanic contact between the one or more airbridge structures (240) and the patterned metallization layer (211) with a resistance smaller than a predefined threshold at operating temperatures, for preserving qubit coherence and/or maintaining superconductivity in superconductive electronics;
- fabricating (150) one or more 3D integration modules (251, 252) by electroplating predefined regions of the integrated metallization layer.

2. The method according to claim 1, wherein the integrated metallization layer (220) comprises a barrier layer (221) and a seed layer (222).

3. The method according to claim 2, the method comprising locally etching the seed layer using a same mask as for patterning (130) the first resist layer (230).

4. The method according to any of the previous claims, wherein patterning (130) the first resist layer comprises a reflow step for making tapered sidewalls.

5. The method (100) according to any of the previous claims, wherein the integrated metallization layer (220) is deposited before providing and patterning the first resist layer (230) and wherein the one or more airbridge structures (240) are formed (140) by:
- depositing (141a) the superconductive material using thin-film deposition;
- patterning and etching (142a) the deposited superconductive material, using a second resist layer (242a) to define regions for the one or more airbridge structures, to obtain the one or more airbridge structures;
- removing (143a) the second resist layer (242a) and the first resist layer (230),
- after fabricating (150) the 3D integration modules (251, 252), etching (144a) the integrated metallization layer (220) to release the one or more airbridge structures (240) and the 3D integration modules (251, 252).

6. The method (100) according to any of the claims 1 to 4, wherein the integrated metallization layer (220) is deposited after providing and patterning the first resist layer (230) and wherein the one or more airbridge structures (240) are formed by:
- applying (141b) a second resist layer (241b) to define regions for the one or more airbridge structures (240);
- electroplating (142b) the superconductive material of the one or more airbridge structures (240) in the regions defined by the second resist layer (241b);
- after fabricating (150) the 3D integration modules (251, 252), providing (143b) a protection resist (243b) for protecting the 3D integration modules (251, 252) and the one or more airbridge structures (240), etching (144b) the integrated metallization layer (220) and removing (145b) resist material to release the one or more airbridge structures (240) and the 3D integration modules (251, 252).

7. The method (100) according to any of the claims 1 to 4, wherein the integrated metallization layer (220) is deposited after providing and patterning the first resist layer (230) and wherein the one or more airbridge structures (240) are formed by:
- applying (141c) a second resist layer (241c) to define regions for the one or more airbridge structures;
- electroplating (142c) a metal hardmask (242c) in the regions defined by the second resist layer (241c);
- after fabricating (150) the 3D integration modules (251, 252), providing (143c) a protection resist (243c) for protecting the 3D integration modules (251, 252) while having the metal hardmask exposed, etching (144c) the integrated metallization layer (220) except for the regions where the metal hardmask (242c) serves as protection and in regions where the protection resist (243c) serves as a protective layer, removing (145c) any remaining metal hardmask (242c) and removing (146c) resist material to release the one or more airbridge structures (240).

8. The method (100) according to any of the previous claims wherein the one or more airbridge structures (240) have a length between contacts on the patterned metallization layer (211) between 20 µm and 100 µm.

9. The method (100) according to any of the previous claims wherein the one or more airbridge structures (240) have a width of more than 10 µm.

10. The method (100) according to any of the previous claims, wherein the one or more airbridge structures (240) are formed (130) using electroplating and have a width of more than 100 µm.

11. The method (100) according to any of the previous claims, wherein the electroplating step used for fabricating (140) the 3D integration modules (251, 252) includes forming bumps made of a superconducting material to enable superconducting connections between bonded wafers.

12. A method for forming a quantum processor, comprising:
- fabricating one or more airbridge structures (240) and one or more 3D integration modules (251, 252) on a patterned metallization layer (211) of a wafer comprising qubits and/or superconducting electronics, using a method (100) according to any of the previous claims;
- bonding the wafer to an additional wafer, comprising 3D integration modules, using the 3D integration modules of both wafers to establish electrical and mechanical connections.

13. The method according to claim 12, wherein at least one of the one or more airbridge structures (240) is configured to mitigate crosstalk and spurious modes in the quantum processor.
